# EUROPÄISCHE PATENTSCHRIFT

(11) **EP 2 836 966 B1**
(45) Veröffentlichungstag und Bekanntmachung des Hinweises auf die Patenterteilung: **28.03.2018**
(21) Anmeldenummer: 13717708.5
(22) Anmeldetag: 04.04.2013
(51) Int. Cl.: G06K 19/077

(54) **TRANSPONDERLAGE UND VERFAHREN ZU DEREN HERSTELLUNG**
TRANSPONDER LAYER AND METHOD FOR PRODUCING SAME
COUCHE TRANSPONDEUR ET PROCÉDÉ DE FABRICATION DE LADITE COUCHE

(30) Priorität: 10.04.2012 DE 102012205768
(43) Veröffentlichungstag der Anmeldung: 18.02.2015
(73) Patentinhaber: Smartrac IP B.V., 1077 XX Amsterdam (NL)
(72) Erfinder: KUSCHEWSKI, Martin, 87616 Marktoberdorf (DE); RIETZLER, Manfred, 87616 Marktoberdorf (DE)
(74) Vertreter: advotec.
(86) Internationale Anmeldenummer: PCT/EP2013/001000
(87) Internationale Veröffentlichungsnummer: WO 2013/152840

(56) Entgegenhaltungen:
- EP-A2- 1 054 346
- US-B1- 6 374 486

## Beschreibung

Die vorliegende Erfindung betrifft eine Transponderlage, insbesondere zur Herstellung einer Chipkarte, mit einem Antennensubstrat, das auf einer Antennenseite mit einer aus einem Drahtleiter mit im Wesentlichen kreisrundem Querschnitt gebildeten Antenne versehen ist, und eine durch eine Ausnehmung im Antennensubstrat gebildete Chipaufnahme aufweist, in der ein Chip aufgenommen ist, wobei Drahtleiterenden, die zur Ausbildung von Anschlussenden der Antenne dienen, an einem gegenüber der Rückseite des Antennensubstrats zurückversetzten Boden der Chipaufnahme ausgebildet sind, und der Chip derart in der Chipaufnahme aufgenommen ist, dass auf einer Kontaktseite des Chips angeordnete Anschlusskontakte mit Kontaktabflachungen der Anschlussenden kontaktiert sind, und der Chip mit seiner den Anschlusskontakten gegenüberliegenden Rückseite seines Halbleiterkörpers im Wesentlichen bündig mit der Rückseite des Antennensubstrats angeordnet ist, wobei die Kontaktabflachungen der Drahtleiterenden im Vergleich zu der im Querschnitt der Drahtleiterenden konvexen Kontaktstruktur vergrößerte Anschlussflächen ausbilden.

Des Weiteren bezieht die vorliegende Erfindung sich auf ein Karteninlay mit einer Transponderlage sowie eine mit einem solchen Karteninlay hergestellte Chipkarte und ein Verfahren zur Herstellung einer Transponderlage.
Zur Herstellung von Transponderanordnungen, die zur berührungslosen Kommunikation mit einem Lesegerät dienen und auf einem Trägersubstrat einen mit einer Antenne kontaktierten Chip aufweisen, ist es bekannt, mehrlagige Laminatstrukturen zu verwenden, wobei eine Laminatlage mit einer aus einem Drahtleiter gebildeten Antenne versehen ist, deren Anschlussenden mit dem Chip kontaktiert sind. Derartige Transponderanordnungen werden beispielsweise als kontaktlose Chipkarte ausgeführt oder sind etwa auch als Transponder-Tag oder Transponder-Token bekannt.
Insbesondere bei der Herstellung von kontaktlosen Chipkarten ist es bekannt, zur Vereinfachung der Kontaktierung des Chips sowie zur Erzielung eines mechanischen Schutzes für den Chip den Chip in einer Gehäusung auf einem Kontaktträger anzuordnen, wobei der Kontaktträger zusammen mit dem in der Gehäusung aufgenommen Chip ein Chipmodul ausbildet. Das Chipmodul weist auf seiner durch den Kontaktträger ausgebildeten Kontaktoberfläche gegenüber den Anschlussflächen des Chips vergrößerte Modulkontaktflächen auf, die die Kontaktierung des Chips mit den Anschlussenden der Antenne vereinfachen.
Das Chipmodul weist im Vergleich zu den Abmessungen des Halbleiterkörpers des Chips wesentlich vergrößerte äußere Abmessungen auf. Insbesondere ist die Höhe des Chipmoduls wesentlich größer als die Höhe des eigentlichen Chips, so dass die Anordnung eines Chipmoduls in einer Laminatstruktur bereits eine entsprechende Anzahl von Laminatlagen voraussetzt. Bei bekannten, eine Laminatstruktur aufweisenden Karten ist es daher regelmäßig so, dass bereits eine Laminatlage für die Unterbringung des mit den vergrößerten Anschlussflächen versehenen Kontaktträges des Chipmoduls benötigt wird und eine zweite Laminatlage, um die den Halbleiterkörper des Chips umschließende Gehäusung in der Laminatstruktur unterzubringen. Wenn man davon ausgeht, dass regelmäßig zur Abdeckung der Antenne des Antennensubstrats sowie zur Abdeckung des Chipmoduls jeweils mindestens eine weitere Laminatlage erforderlich wird, so ergibt sich bei den bekannten, als Laminatstruktur aufgebauten Chipkarten eine Mindestanzahl von vier Laminatlagen, die möglicherweise noch durch weitere äußere Laminatlagen ergänzt werden, welche als Sichtlagen maßgeblich für die äußere Gestaltung der Chipkarten sind.

Aus der EP 1 054 346 A2 ist eine kontaktlose Chipkarte mit einem Paar von Außenlagen bekannt, wobei in einer Kernlage der Chipkarte eine durchgängige Ausnehmung zum Einsetzen eines Chips erzeugt wird, und auf der Rückseite der Kernlage eine Antenne aus einem Leiterdraht angeordnet wird. Antennenenden auf der Rückseite der Kernlage sind im Bereich der Ausnehmung angeordnet, wobei ein Chip mit seinen Anschlussflächen voraus in die Ausnehmung eingesetzt wird, und dort so mit den Enden der Antenne verbunden wird, dass der Chip samt seiner Kontaktflächen bündig in der Kernlage zur Anlage kommt. Weiter wird die Kernlage mit der auf der Rückseite ausgeführten Antennenanordnung und dem in der Ausnehmung befindlichen Chip auf beiden Seiten von jeweils einer Außenlage abgedeckt. Die Antenne bzw. der Drahtleiter, der zum Bilden der Antenne verwendet wird, ist flach und weist einen rechteckigen Querschnitt auf.

Die US 6,374,486 B1 beschreibt eine Chipkarte und ein Verfahren zu deren Herstellung, wobei ebenfalls eine Ausnehmung in einer Substratlage ausgebildet wird, wobei auf einer Rückseite der Substratlage eine Antenne aus einem Drahtleiter so angeordnet wird, dass die Enden der Antenne auf der Rückseite des Substrats entlang der Ausnehmung verlaufen, und ein Chip mit seinen Anschlussflächen so in die Ausnehmung eingesetzt wird, dass die Kontaktflächen die auf der Rückseite des Substrats verlaufenden Enden der Antenne im Bereich der Ausnehmung kontaktieren. Auch hier weist die Antenne bzw. der Drahtleiter einen rechteckigen Querschnitt auf.

Der vorliegenden Erfindung liegt die Aufgabe zugrunde, eine Transponderlage, insbesondere zur Herstellung einer Chipkarte, derart weiterzubilden, dass eine verbesserte bzw. erleichterte Kontaktierung eines Chips an einem ansonsten kreisrunden Drahtleiter bzw. einer Antenne ermöglicht wird.

Zur Lösung dieser Aufgabe weist eine erfindungsgemäße Transponderlage zur Herstellung einer Chipkarte die Merkmale des Anspruchs 1, ein erfindungsgemäßes Karteninlay die Merkmale des Anspruchs 4, eine erfindungsgemäße Chipkarte die Merkmale des Anspruchs 5 und das erfindungsgemäße Verfahren die Merkmale des Anspruchs 7 auf.

Die erfindungsgemäße Transponderlage weist ein Antennensubstrat auf, das auf einer Antennenseite mit einer aus einem Drahtleiter mit im Wesentlichen kreisrundem Querschnitt gebildeten Antenne versehen ist und eine durch eine Ausnehmung im Antennensubstrat gebildete Chipaufnahme aufweist, in der ein Chip aufgenommen ist, wobei Drahtleiterenden, die zur Ausbildung von Anschlussenden in der Antenne dienen, an einem gegenüber der Rückseite des Antennensubstrats zurückversetzten Boden der Chipaufnahme ausgebildet sind, und der Chip derart in der Chipaufnahme aufgenommen ist, dass auf einer Kontaktseite des Chips angeordnete Anschlusskontakte mit Kontaktabflachungen der Anschlussenden kontaktiert sind, und der Chip mit seiner den Anschlusskontakten gegenüberliegenden Rückseite seines Halbleiterkörpers im Wesentlichen bündig mit der Rückseite des Antennensubstrats angeordnet ist, wobei die Kontaktabflachungen der Drahtleiterenden im Vergleich zu der im Querschnitt der Drahtleiterenden konvexen Kontaktstruktur vergrößerte Anschlussflächen ausbilden.

Die erfindungsgemäß ausgebildete Transponderlage ermöglicht die Unterbringung des Chips unter Verzicht auf eine den Chip aufnehmende Gehäusung in lediglich einer Laminatlage. Dies wird insbesondere dadurch erreicht, dass die Drahtleiterenden, die die Anschlussenden in der Antenne zur Kontaktierung mit dem Chip ausbilden, Kontaktabflachungen aufweisen, die unmittelbar mit den Anschlusskontakten des Chips kontaktiert sind, ohne dass zwischen dem Chip und den Anschlussenden der Antenne ein Kontaktträger zur Ausbildung vergrößerter Anschlussflächen vorgesehen wäre.

Die Kontaktabflachungen der Drahtleiterenden bilden im Vergleich zu der im Querschnitt der Drahtleiterenden konvexen Kontaktkontur vergrößerte Anschlussflächen aus, die eine sichere Kontaktierung mit den Anschlussflächen des Chips ermöglichen. Durch die im Wesentlichen oberflächenbündige Anordnung des Chips bzw. des Halbleiterkörpers des Chips in dem Antennensubstrat ist der Chip sicher in der Ausnehmung des Antennensubstrats aufgenommen, ohne dass aus der Ausnehmung des Antennensubstrats hervorstehende Bereiche des Chips eine zusätzliche Laminatlage erforderlich machen würden. Damit ist eine Transponderlage geschaffen, die in ihren äußeren Abmessungen allein durch das Antennensubstrat definiert ist und insbesondere keine weitere Laminatlage neben dem Antennensubstrat zur Unterbringung des Chips erforderlich macht.

Bei einer bevorzugten Ausführungsform der Transponderlage ist die Chipaufnahme als eine Fensteröffnung im Antennensubstrat ausgebildet, und die Kontaktabflachungen der Drahtleiterenden bilden den Boden der Chipaufnahme. Diese Ausführungsform weist den besonderen Vorteil auf, dass die Ausnehmung im Antennensubstrat bereits vor Anordnung der aus dem Drahtleiter gebildeten Antenne auf dem Antennensubstrat ausgebildet sein kann, so dass die Drahtleiterenden frei zugänglich für eine nachfolgende Kontaktierung mit dem Chip sind, ohne dass hierzu noch eine besondere Bearbeitung des Antennensubstrats notwendig wäre.

Bei einer alternativen Ausführungsform der Transponderlage ist die Chipaufnahme als eine Vertiefung im Antennensubstrat ausgebildet mit einem im Antennensubstrat ausgebildeten Boden, wobei die Kontaktabflachungen der Anschlussenden im Boden der Chipaufnahme angeordnet sind. Diese vorteilhafte Ausführungsform ermöglicht es, die Kontaktabflachungen der Drahtleiterenden und die Ausnehmung in einem gemeinsamen Bearbeitungsvorgang auszubilden.

Bei dem erfindungsgemäßen Karteninlay, das die erfindungsgemäße Transponderlage aufweist, ist die Transponderlage als Zwischenlage zwischen einer unteren Decklage und einer oberen Decklage in einem Lagenverbund mit den Decklagen angeordnet, derart, dass die untere Decklage auf der Antennenseite des Antennensubstrats angeordnet ist und die obere Decklage sowohl auf der Rückseite des Antennensubstrats als auch auf der Rückseite des Halbleiterkörpers des Chips angeordnet ist.

Hierdurch wird ein Karteninlay, das insbesondere als Halbzeug bei der Herstellung von Chipkarten verwendbar ist, vorgeschlagen, das bereits die geschützte Anordnung sowohl der Antenne als auch des Chips in einer Laminatlagenstruktur mit lediglich drei Laminatlagen aufweist.

Die erfindungsgemäße Chipkarte weist in einer Minimalkonfiguration das erfindungsgemäße Karteninlay auf, wobei eine untere Außenlage der Chipkarte durch die untere Decklage des Karteninlays und eine obere Außenlage der Chipkarte durch die obere Decklage des Karteninlays gebildet sind.

Hierdurch bildet die Chipkarte eine sogenannte "weiße Karte", die beispielsweise durch eine unmittelbare Kennzeichnung bzw. Bedruckung der Außenlage die Herstellung einer vollständigen Chipkarte mit einer Laminatstruktur aus lediglich drei Laminatlagen, nämlich der Transponderlage, der unteren Decklage und der oberen Decklage, ermöglicht.

Selbst dann, wenn gemäß einer Ausführungsform der Chipkarte diese zusätzlich zu der unteren und oberen Decklage mit einer unteren Außenlage und einer oberen Außenlage zur Erzielung einer besonderen Ausgestaltung der Chipkarte versehen ist, zeichnet sich auch diese individuell ausgestaltete Chipkarte immer noch durch eine Laminatstruktur mit einer möglichst geringen Anzahl von Laminatlagen aus.

Bei Durchführung des erfindungsgemäßen Verfahrens wird ein auf einer Antennenseite mit einer aus einem Drahtleiter gebildeten Antenne versehenes Antennensubstrat im Bereich einer im Antennensubstrat ausgebildeten Ausnehmung, über deren Boden sich aus dem Drahtleiter gebildete Anschlussenden der Antenne erstrecken, von der Rückseite des Antennensubstrats her mit Energie beaufschlagt, derart, dass an den Anschlussenden der Antenne zur Rückseite des Antennensubstrats hin gerichtete Kontaktabflachungen ausgebildet werden. Nachfolgend wird eine Kontaktierung der Kontaktabflachungen mit auf der Kontaktseite eines Chips angeordneten Anschlusskontakten des Chips durchgeführt, derart, dass der Chip mit seiner den Anschlusskontakten gegenüberliegenden Rückseite seines Halbleiterkörpers im Wesentlichen bündig mit der Rückseite des Antennensubstrats im Antennensubstrat aufgenommen ist.

Bei einer ersten vorteilhaften Variante des Verfahrens erfolgt die Ausbildung der Kontaktabflachungen mittels eines Umformvorgangs des die Anschlussenden der Antenne bildenden Drahtleiters, so dass beispielsweise die Ausbildung der Kontaktabflachungen mittels eines Stempelwerkzeugs, das eine Verformung des Drahtleiterquerschnitts zur Ausbildung der Kontaktabflachungen bewirkt, durchgeführt werden kann.

Alternativ ist es auch möglich, die Ausbildung der Kontaktabflachungen mittels eines mechanischen Bearbeitungsverfahrens durchzuführen, das spanabhebend, also beispielsweise mit einem Fräswerkzeug ausgeführt, oder auch abrasiv, also beispielsweise mit einem Schleifwerkzeug ausgeführt, erfolgen kann.

Eine berührungslose Bearbeitung der Drahtleiterenden zur Ausbildung der Kontaktabflachungen wird möglich, wenn die Ausbildung der Kontaktabflachungen mittels einer Laserbeaufschlagung der Drahtleiterenden erfolgt.

Für die Kontaktierung der Anschlusskontakte des Chips mit den Kontaktabflachungen der Drahtleiterenden hat es sich insbesondere in dem Fall, dass die Anschlusskontakte des Chips mit metallischen Kontakterhöhungen versehen sind, als vorteilhaft herausgestellt, wenn zur Kontaktierung eine Beaufschlagung des die Anschlussenden der Antenne bildenden Drahtleiters mit Druck und Temperatur erfolgt.

Insbesondere in dem Fall, dass die Anschlusskontakte des Chips für die nachfolgende Kontaktierung mit Kontakterhöhungen aus leitendem Kleber versehen sind, hat es sich als vorteilhaft herausgestellt, die Kontaktierung durch eine Beaufschlagung des die Anschlussenden der Antenne bildenden Drahtleiters mit Druck durchzuführen.

Unabhängig von der Art und Weise der Präparierung der Anschlusskontakte des Chips mit Kontakterhöhungen weisen diese in jedem Fall den Vorteil auf, dass durch die Höhe des beim Kontaktierungsvorgang ausgeübten Drucks die angestrebte, im Wesentlichen bündige Anordnung der Rückseite des Halbleiterkörpers des Chips mit der Rückseite des Antennensubstrats über die Höhe des auf die Kontakterhöhungen wirkenden Drucks eingestellt werden kann.

Nachfolgend wird eine vorteilhafte Ausführungsform der Transponderlage sowie deren Verwendung zur Herstellung eines Karteninlays bzw. einer Chipkarte anhand der Zeichnung näher erläutert.

Es zeigen:
- **Fig. 1**: eine Transponderlage in Draufsicht;
- **Fig. 2**: eine Transponderlage in einer Längsschnittdarstellung;
- **Fig. 3**: ein unter Verwendung der Transponderlage hergestelltes Chipkarten-Inlay in einer Längsschnittdarstellung;
- **Fig. 4a, 4b**: die Herstellung einer Transponderlage basierend auf einer ersten Ausführungsform eines Antennensubstrats;
- **Fig. 5a, 5b**: die Kontaktierung eines Chips mit dem in den Fig. 4a, 4b dargestellten Antennensubstrat;
- **Fig. 6a, 6b**: die Herstellung einer Transponderlage basierend auf einer zweiten Ausführungsform des Transpondersubstrats;
- **Fig. 7**: die Kontaktierung des Chips mit dem in den **Fig. 6a, 6b** dargestellten Transpondersubstrat.

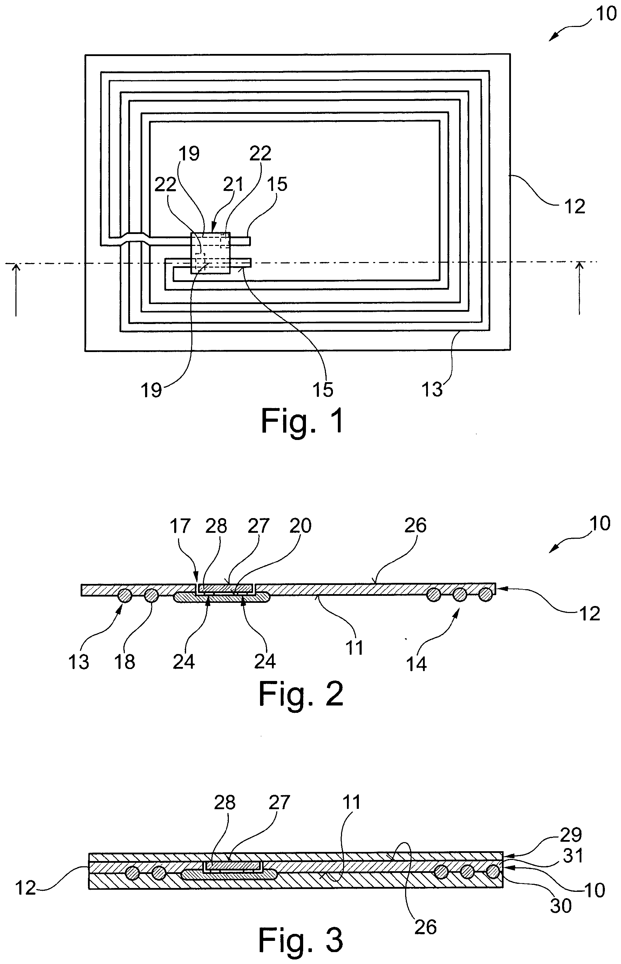

In den **Fig. 1** und **2** ist eine Transponderlage 10 dargestellt, die auf einer Antennenseite 11 eines Antennensubstrats 12 mit einer aus einem Drahtleiter 13 gebildeten Antenne 14 versehen ist. Die Antenne 14 weist zwei aus dem Drahtleiter 13 gebildete Anschlussenden 15 auf, die auf der Antennenseite 11 über eine im Antennensubstrat 12 ausgebildete Fensteröffnung 17 hinweggeführt sind.

Wie insbesondere der Darstellung in **Fig. 2** zu entnehmen ist, ist der Drahtleiter 13 zur Ausbildung der Antenne 14 im vorliegenden Fall mit einem Teil seines Drahtleiterquerschnitts 18 in das beispielsweise aus PVC gebildete Antennensubstrat 12 eingebettet. Wie ferner aus den **Fig. 1 und 2** zu ersehen ist, weist der Drahtleiter 13 im Bereich seiner über die Fensteröffnung 17 hinweggeführten Anschlussenden 15 Kontaktabflachungen 19 auf, die einen Boden 20 der durch die Fensteröffnung 17 im Antennensubstrat 12 gebildeten Ausnehmung ausbilden. In die Fensteröffnung 17 ist ein Chip 21 eingesetzt, der auf seinen Anschlusskontakten 22 mit hier beispielsweise metallisch ausgebildeten Kontakterhöhungen 24 versehen ist, die mit den zu einer Rückseite 26 des Antennensubstrats 12 hin gerichteten Kontaktabflachungen 19 kontaktiert sind. Dabei ist der Chip 21 derart in der Fensteröffnung 17 aufgenommen, dass eine Rückseite 27 eines Halbleiterkörpers 28 des Chips 21 bündig mit der Rückseite 26 des Antennensubstrats 12 ausgerichtet ist.

**Fig. 3** zeigt ein Karteninlay 29, das als Laminatstruktur ausgebildet ist und die in **Fig. 2** dargestellte Transponderlage 10 als Zwischenlage zwischen einer unteren Decklage 30, die auf der Antennenseite 11 des Antennensubstrats 12 angeordnet ist, und einer oberen Decklage 31, die auf der Rückseite 26 des Antennensubstrats 12 angeordnet ist, in einem Lagenverbund mit den Decklagen 30, 31 aufnimmt.

Insbesondere befindet sich die obere Decklage 31 sowohl in einem Lagenverbund mit dem Antennensubstrat 12 als auch in einem Verbund mit dem Halbleiterkörper 28.

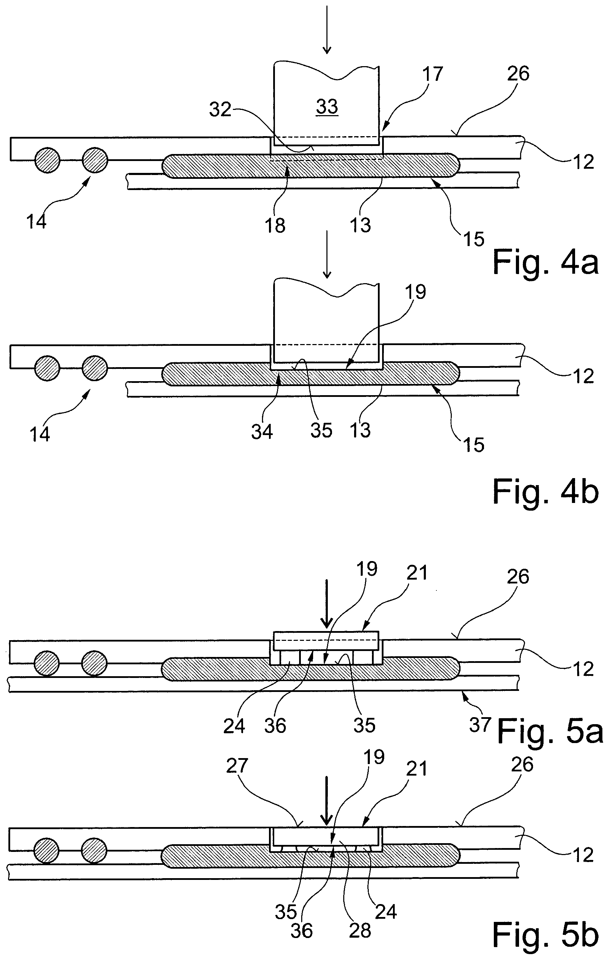

In den **Fig. 4a** und **4b** ist eine Möglichkeit zur Herstellung der Kontaktabflachungen 19 in den von dem Drahtleiter 13 ausgebildeten Anschlussenden 15 der Antenne 14 dargestellt. Wie sich aus der Figurenabfolge der **Fig. 4a** und **4b** ergibt, wird ausgehend von einem Zustand, in dem sich, wie **Fig. 4a** zeigt, der Drahtleiter 13 mit seinem ursprünglichen Drahtleiterquerschnitt 18 über die Fensteröffnung 17 im Antennensubstrat 12 erstreckt, ein mit seinem Endquerschnitt 32 im Wesentlichen mit dem Querschnitt der Fensteröffnung 17 übereinstimmender Druckstempel 33 von der Rückseite 26 des Antennensubstrats 12 her gegen den Drahtleiter 13 gepresst, so dass mittels eines Umformvorgangs im Bereich der Fensteröffnung 17 die Kontaktabflachungen 19 ausgebildet werden, die einen von dem ursprünglichen Drahtleiterquerschnitt 18 abweichenden Kontaktquerschnitt 34 aufweisen, der eine im Wesentlichen ebene Kontaktfläche 35 im Bereich der Kontaktabflachung 19 ausbildet.

In den **Fig. 5a** und **5b** wird der Kontaktierungsvorgang dargestellt, in dessen Verlauf von der Rückseite 26 des Antennensubstrats 12 her der Chip 21 mit seiner Kontaktseite 36 gegen die Kontaktabflachungen 19 gerichtet in die Fensteröffnung 17 eingesetzt wird, wobei die Kontakterhöhungen 24 zur Anlage gegen die Kontaktflächen 35 der Kontaktabflachungen gelangen. Bei dem in den **Fig. 5a** und **5b** beispielsweise dargestellten Thermokompressionsverfahren wird nunmehr unter gleichzeitiger Beaufschlagung des Chips 21 mit Druck ein Aufschmelzen der Kontakterhöhungen 24 bewirkt, wobei Druck und Temperatur so aufeinander abgestimmt sind, dass sich die in **Fig. 5b** dargestellte flächenbündige Anordnung der Rückseite 27 des Halbleiterkörpers 28 des Chips 21 mit der Rückseite 26 des Antennensubstrats 12 einstellt. Vorzugsweise wird der für die Kontaktierung notwendige Druck auf die Rückseite 27 des Halbleiterkörpers 28 aufgebracht, wohingegen die Beheizung, die zum Aufschmelzen der Kontakterhöhungen 24 erfolgt, durch Beheizung des Drahtleiters 13 über eine beim Kontaktierungsvorgang verwendete Montageplatte 37 erfolgt.

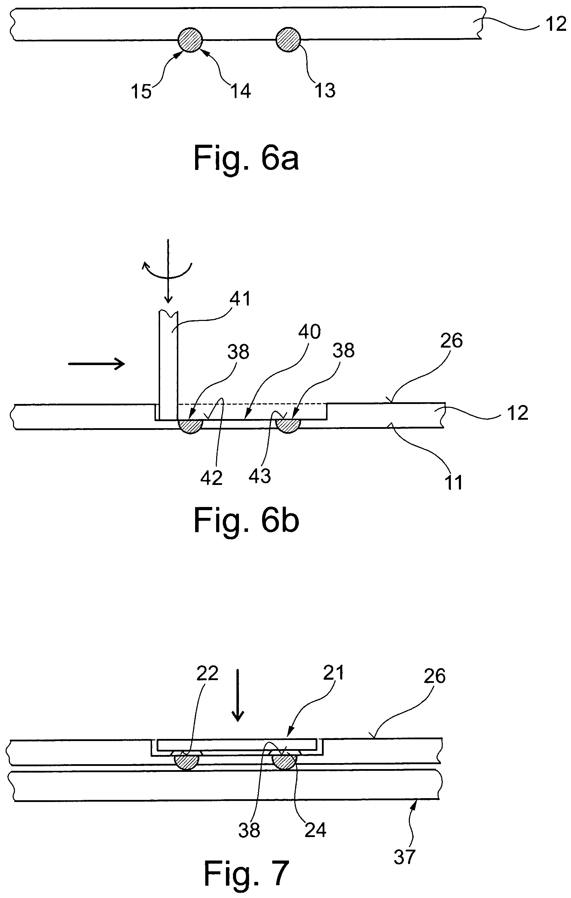

In den **Fig. 6a** und **6b** ist eine weitere Möglichkeit zur Erzeugung von Kontaktabflachungen 38 im Bereich des die Anschlussenden 15 der Antenne 14 ausbildenden Drahtleiters 13 dargestellt, wobei die Herstellung der Kontaktabflachungen 38 gleichzeitig mit der Ausbildung einer Vertiefung 40 im Antennensubstrat 12 erfolgt, die zur Aufnahme des Chips 21 (**Fig. 7**) dient.

Bei der hier dargestellten Variante wird ein rotierendes Fräswerkzeug 41 von der Rückseite 26 des Antennensubstrats 12 her in Richtung auf den auf der Antennenseite 11 des Antennensubstrats 12 angeordneten Drahtleiter 13 zugeführt. Dabei wird im Antennensubstrat 12 ein Boden 42 der Vertiefung 40 ausgebildet, in dem die Kontaktabflachungen 38 bündig mit ihren Kontaktflächen 43 angeordnet sind.

Analog zu den Darstellungen in den **Fig. 5a** und **5b** kann die Kontaktierung des Chips 21 mit der auf dem Antennensubstrat 12 angeordneten Antenne 14 dadurch erfolgen, dass der Chip von der Rückseite 26 des Antennensubstrats 12 her in die Vertiefung 40 eingesetzt und dabei über die auf den Anschlusskontakten 22 des Chips 21 angeordneten Kontakterhöhungen 24 mit den Kontaktabflachungen 38 kontaktiert wird.

## Patentansprüche

1. Transponderlage (10), insbesondere zur Herstellung einer Chipkarte, mit einem Antennensubstrat (12), das auf einer Antennenseite (11) mit einer aus einem Drahtleiter (13) mit einem im Wesentlichen kreisrunden Querschnitt gebildeten Antenne (14) versehen ist, und eine durch eine Ausnehmung im Antennensubstrat gebildete Chipaufnahme aufweist, in der ein Chip (21) aufgenommen ist, wobei Drahtleiterenden, die zur Ausbildung von Anschlussenden (15) der Antenne dienen, an einem gegenüber der Rückseite (26) des Antennensubstrats (12) zurückversetzten Boden (20) der Chipaufnahme ausgebildet sind, und der Chip derart in der Chipaufnahme aufgenommen ist, dass auf einer Kontaktseite (36) des Chips angeordnete Anschlusskontakte (22) mit Kontaktabflachungen (19) der Anschlussenden (15) kontaktiert sind, und der Chip mit seiner den Anschlusskontakten gegenüberliegenden Rückseite (27) seines Halbleiterkörpers (28) im Wesentlichen bündig mit der Rückseite des Antennensubstrats angeordnet ist, wobei die Kontaktabflachungen der Drahtleiterenden im Vergleich zu der im Querschnitt der Drahtleiterenden konvexen Kontaktstruktur vergrößerte Anschlussflächen ausbilden.

2. Transponderlage nach Anspruch 1,
**dadurch gekennzeichnet,**
**dass** die Chipaufnahme als eine Fensteröffnung (17) im Antennensubstrat (12) ausgebildet ist, und die Kontaktabflachungen (19) der Anschlussenden (15) den Boden (20) der Chipaufnahme ausbilden.

3. Transponderlage nach Anspruch 1,
**dadurch gekennzeichnet,**
**dass** die Chipaufnahme als eine Vertiefung (40) im Antennensubstrat (12) ausgebildet ist mit einem vom Antennensubstrat (12) ausgebildeten Boden (42), wobei die Kontaktabflachungen (38) der Anschlussenden (15) im Boden (42) der Chipaufnahme angeordnet sind.

4. Karteninlay (29) mit einer Transponderlage (10) nach einem der vorangehenden Ansprüche,
**dadurch gekennzeichnet,**
**dass** die Transponderlage als Zwischenlage zwischen einer unteren Decklage (30) und einer oberen Decklage (31) in einem Lagenverbund mit den Decklagen angeordnet ist, derart, dass die untere Decklage auf der Antennenseite (11) des Antennensubstrats (12) angeordnet ist und die obere Decklage sowohl auf der Rückseite (26) des Antennensubstrats (12) als auch auf der Rückseite (27) des Halbleiterkörpers (28) des Chips (21) angeordnet ist.

5. Chipkarte mit einem Karteninlay nach Anspruch 4,
**dadurch gekennzeichnet,**
**dass** eine untere Außenlage der Chipkarte durch die untere Decklage (30) des Karteninlays (29) und eine obere Außenlage der Chipkarte durch die obere Decklage (31) des Karteninlays gebildet sind.

6. Chipkarte mit einem Karteninlay nach Anspruch 4,
**dadurch gekennzeichnet,**
**dass** eine untere Außenlage der Chipkarte auf der unteren Decklage des Karteninlays und eine obere Außenlage der Chipkarte auf der oberen Decklage des Karteninlays angeordnet sind.

7. Verfahren zur Herstellung einer Transponderlage (10) nach einem der Ansprüche 1 bis 3,
**dadurch gekennzeichnet,**
**dass** ein auf einer Antennenseite (11) mit einer aus einem Drahtleiter (13) gebildeten Antenne (14) versehenes Antennensubstrat (12) im Bereich einer im Antennensubstrat ausgebildeten Chipaufnahme, über deren Boden (20, 42) sich aus dem Drahtleiter gebildete Anschlussenden (15) der Antenne erstrecken, von der Rückseite (26) des Antennensubstrats her mit Energie beaufschlagt wird, derart, dass an den Anschlussenden der Antenne zur Rückseite des Antennensubstrats hin gerichtete Kontaktabflachungen (19, 38) ausgebildet werden,
und nachfolgend eine Kontaktierung der Kontaktabflachungen mit auf der Kontaktseite (36) eines Chips (21) angeordneten Anschlusskontakten (22) des Chips erfolgt, derart, dass der Chip mit seiner den Anschlusskontakten gegenüberliegenden Rückseite (27) seines Halbleiterkörpers im Wesentlichen bündig mit der Rückseite des Antennensubstrats im Antennensubstrat aufgenommen ist.

8. Verfahren nach Anspruch 7,
**dadurch gekennzeichnet,**
**dass** die Ausbildung der Kontaktabflachungen (19) mittels eines Umformvorgangs des die Anschlussenden (15) der Antenne (14) bildenden Drahtleiters (13) erfolgt.

9. Verfahren nach Anspruch 7,
**dadurch gekennzeichnet,**
**dass** die Ausbildung der Kontaktabflachungen (38) mittels eines mechanischen Bearbeitungsverfahrens des die Anschlussenden (15) der Antenne (14) bildenden Drahtleiters (13) erfolgt.

10. Verfahren nach Anspruch 7,
**dadurch gekennzeichnet,**
**dass** die Ausbildung der Kontaktabflachungen mittels einer Laserbeaufschlagung des die Anschlussenden in der Antenne bildenden Drahtleiters erfolgt.

11. Verfahren nach einem der Ansprüche 7 bis 10,
**dadurch gekennzeichnet,**
**dass** die Kontaktierung der mit metallischen Kontakterhöhungen (24) versehenen Anschlusskontakte (22) des Chips (21) mit den Kontaktabflachungen (19, 38) durch eine Beaufschlagung des die Anschlussenden (15) der Antenne (14) bildenden Drahtleiters (13) mit Druck und Temperatur erfolgt.

12. Verfahren nach einem der Ansprüche 7 bis 10,
**dadurch gekennzeichnet,**
**dass** die Kontaktierung der mit Kontakterhöhungen aus leitendem Kleber versehenen Anschlusskontakte des Chips mit den Kontaktabflachungen durch eine Beaufschlagung des die Anschlussenden der Antenne bildenden Drahtleiters mit Druck erfolgt.

## Claims

1. A transponder layer (10), in particular for producing a chip card, having an antenna substrate (12), which, on an antenna side (11), is equipped with an antenna (14) formed from a wire conductor (13) having an essentially circular cross-section, and has a chip accommodation which is formed by a recess in the antenna substrate and in which a chip (21) is accommodated, wherein wire conductor ends, which serve to form terminal ends (15) of the antenna, are formed at a bottom (20) of the chip accommodation which is recessed with respect to the rear side (26) of the antenna substrate (12), and the chip is accommodated in the chip accommodation in such a manner that terminal contacts (22) arranged on a contact side (36) of the chip are contacted with flat contact portions (19) of the terminal ends (15), and the chip is arranged with the rear side (27) of its semiconductor body (28) facing the terminal contacts substantially flush with the rear side of the antenna substrate, wherein the flat contact portions of the wire conductor ends form enlarged terminal surfaces in contrast to the contact structure which is convex in the cross-section of the wire conductor ends.

2. The transponder layer according to claim 1,
**characterized in that**
the chip accommodation is formed as a window opening (17) in the antenna substrate (12), and the flat contact portions (19) of the terminal ends (15) form the bottom (20) of the chip accommodation.

3. The transponder layer according to claim 1,
**characterized in that**
the chip accommodation is formed as an indentation (40) in the antenna substrate (12) with a bottom (42) formed by the antenna substrate (12), wherein the flat contact portions (38) of the terminal ends (15) are arranged in the bottom (42) of the chip accommodation.

4. A card inlay (29) having a transponder layer (10) according to one of the preceding claims,
**characterized in that**
the transponder layer is arranged as an intermediate layer between a lower cover layer (30) and an upper cover layer (31) in a layer composite with the cover layers, in such a manner that the lower cover layer is arranged on the antenna side (11) of the antenna substrate (12) and the upper cover layer is arranged both on the rear side (26) of the antenna substrate (12) and on the rear side (27) of the semiconductor body (28) of the chip (21).

5. A chip card having a card inlay according to claim 4,
**characterized in that**
a lower external layer of the chip card is formed by the lower cover layer (30) of the card inlay (29) and an upper external layer of the chip card is formed by the upper cover layer (31) of the card inlay.

6. The chip card having a card inlay according to claim 4,
**characterized in that**
a lower external layer of the chip card is arranged on the lower cover layer of the card inlay and an upper external layer of the chip card is arranged on the upper cover layer of the card inlay.

7. A method for producing a transponder layer (10) according to one of the claims 1 to 3,
**characterized in that**
an antenna substrate (12), which, on an antenna side (11), is equipped with an antenna (14) formed from a wire conductor (13), is subjected to energy from the rear side (26) of the antenna substrate in the area of a chip accommodation, which is formed in the antenna substrate, and over whose bottom (20, 42) terminal ends (15) of the antenna, which are formed from the wire conductor, extend, in such a manner that at the terminal ends of the antenna, flat contact portions (19, 38) which are directed toward the rear side of the antenna substrate are formed,
and subsequently, contacting of the flat contact portions with terminal contacts (22) of a chip which are arranged on the contact side (36) of the chip (21) is effected in such a manner that the chip is accommodated in the antenna substrate with the rear side (27) of its semiconductor body facing the terminal contacts substantially flush with the rear side of the antenna substrate.

8. The method according to claim 7,
**characterized in that**
forming the flat contact portions (19) is effected by means of a reforming process of the wire conductor (13) which forms the terminal ends (15) of the antenna (14).

9. The method according to claim 7,
**characterized in that**
forming the flat contact portions (38) is effected by means of a mechanical machining process of the wire conductor (13) which forms the terminal ends (15) of the antenna (14).

10. The method according to claim 7,
**characterized in that**
forming the flat contact portions is effected by means of a laser treatment of the wire conductor which forms the terminal ends in the antenna.

11. The method according to one of the claims 7 to 10,
**characterized in that**
contacting the terminal contacts (22) of the chip (21), which are equipped with metallic contact elevations (24), with the flat contact portions (19, 38) is effected by subjecting the wire conductor (13) which forms the terminal ends (15) of the antenna (14) to pressure and temperature.

12. The method according to one of the claims 7 to 10,
**characterized in that**
contacting the terminal contacts of the chip, which are equipped with contact elevations from a conductive adhesive, with the flat contact portions is effected by subjecting the wire conductor which forms the terminal ends of the antenna to pressure.

## Revendications

1. Couche (10) transpondeur, en particulier pour la production d'une carte à puce, ayant un substrat (12) d'antenne qui, sur un côté (11) d'antenne, est pourvu d'une antenne (14) faite d'un fil (13) conducteur ayant une section transversale essentiellement circulaire et qui comprend un logement de puce, qui est formé par un évidement dans le substrat d'antenne et dans lequel une puce (21) est logée, des extrémités de fil conducteur, qui servent à former des extrémités (15) de connexion de l'antenne, étant formées sur un fond (20) du logement de puce décalé par rapport au côté (26) arrière du substrat (12) d'antenne et la puce étant logée dans le logement de puce, de telle manière que des contacts (22) de connexion disposés sur un côté (36) de contact de la puce soient contactés avec des zones (19) de contact aplaties des extrémités (15) de connexion et que la puce, avec son côté (27) arrière de son corps (28) semi-conducteur opposé aux contacts de connexion, soit disposée essentiellement à fleur avec le côté arrière du substrat d'antenne, lesdites zones de contact aplaties des extrémités de fil conducteur formant des surfaces de connexion élargies en comparaison avec la structure de contact qui est convexe dans la section transversale des extrémités de fil conducteur.

2. Couche transpondeur selon la revendication 1,
**caractérisée en ce que**
le logement de puce est formé en tant qu'ouverture (17) de fenêtre dans le substrat (12) d'antenne et les zones (19) de contact aplaties des extrémités (15) de connexion forment le fond (20) du logement de puce.

3. Couche transpondeur selon la revendication 1,
**caractérisée en ce que**
le logement de puce est formé en tant que renfoncement (40) dans le substrat (12) d'antenne ayant un fond (42) formé par le substrat (12) d'antenne, les zones (38) de contact aplaties des extrémités (15) de connexion étant disposées dans le fond (42) du logement de puce.

4. Incrustation (29) de carte ayant une couche (10) transpondeur selon l'une quelconque des revendications précédentes,
**caractérisée en ce que**
la couche transpondeur est disposée en tant que couche intermédiaire entre une couche (30) de recouvrement inférieure et une couche (31) de recouvrement supérieure dans un composite multicouche ayant lesdites couches de recouvrement, de telle manière que la couche de recouvrement inférieure soit disposée sur le côté (11) d'antenne du substrat (12) d'antenne et que la couche de recouvrement supérieure soit disposée sur le côté (26) arrière du substrat (12) d'antenne aussi bien que sur le côté (27) arrière du corps (28) semi-conducteur de la puce (21).

5. Carte à puce ayant une incrustation de carte selon la revendication 4,
**caractérisée en ce qu'**
une couche extérieure inférieure de la carte à puce est formée par la couche (30) de recouvrement inférieure de l'incrustation (29) de carte et une couche extérieure supérieure de la carte à puce est formée par la couche (31) de recouvrement supérieure de l'incrustation de carte.

6. Carte à puce ayant une incrustation de carte selon la revendication 4,
**caractérisée en ce qu'**
une couche extérieure inférieure de la carte à puce est disposée sur la couche de recouvrement inférieure de l'incrustation de carte et une couche extérieure supérieure de la carte à puce est disposée sur la couche de recouvrement supérieure de l'incrustation de carte.

7. Procédé de production d'une couche (10) transpondeur selon l'une quelconque des revendications 1 à 3,
**caractérisé en ce qu'**
un substrat (12) d'antenne pourvu d'une antenne (14) formée par un conducteur (13) de fil sur un côté (11) d'antenne est soumis à de l'énergie par le côté (26) arrière du substrat d'antenne dans la région d'un logement de puce formé dans le substrat d'antenne, des extrémités (15) de connexion de l'antenne formées par le conducteur de fil s'étendant à travers le fond (20, 42) dudit logement de puce, de telle manière que des zones (19, 38) de contact aplaties orientées vers le côté arrière du substrat d'antenne soient formées aux extrémités de connexion de l'antenne,
et ensuite les zones de contact aplaties sont contactées avec des contacts (22) de connexion d'une puce (21) disposés sur le côté (36) de contact de ladite puce (21), de telle manière que la puce, avec son côté (27) arrière de son corps semi-conducteur opposé aux contacts de connexion, soit logée dans le substrat d'antenne essentiellement à fleur avec le côté arrière du substrat d'antenne.

8. Procédé selon la revendication 7,
**caractérisé en ce que**
les zones (19) de contact aplaties sont formées au moyen d'un procédé de déformation du conducteur (13) de fil constituant les extrémités (15) de connexion de l'antenne (14).

9. Procédé selon la revendication 7,
**caractérisé en ce que**
les zones (38) de contact aplaties sont formées au moyen d'un procédé d'usinage mécanique du conducteur (13) de fil constituant les extrémités (15) de connexion de l'antenne (14).

10. Procédé selon la revendication 7,
**caractérisé en ce que**
les zones de contact aplaties sont formées au moyen d'un traitement laser du conducteur de fil constituant les extrémités de connexion dans l'antenne.

11. Procédé selon l'une quelconque des revendications 7 à 10,
**caractérisé en ce que**
les contacts (22) de connexion de la puce (21) pourvus d'élévations (24) de contact métalliques sont contactés avec les zones (19, 38) de contact aplaties en soumettant le conducteur (13) de fil constituant les extrémités (15) de connexion de l'antenne (14) à de la pression et à de la température.

12. Procédé selon l'une quelconque des revendications 7 à 10,
**caractérisé en ce que**
les contacts de connexion de la puce pourvus d'élévations de contact faites d'un adhésif conducteur sont contactés avec les zones de contact aplaties en soumettant le conducteur de fil constituant les extrémités de connexion de l'antenne à de la pression.
